(19) **Europäisches Patentamt / European Patent Office / Office européen des brevets**

(11) **EP 2 117 116 A2**

(12) # EUROPEAN PATENT APPLICATION

(43) Date of publication:
**11.11.2009 Bulletin 2009/46**

(51) Int Cl.:
**H03F 1/32** (2006.01)    **H03F 3/189** (2006.01)

(21) Application number: **09152026.2**

(22) Date of filing: **04.02.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **07.05.2008 JP 2008121455**

(71) Applicant: **Fujitsu Limited**
**Kawasaki-shi, Kanagawa 211-8588 (JP)**

(72) Inventors:
• **Aoki, Nobuhisa**
  **Kawasaki-shi, Kanagawa 211-8588 (JP)**
• **Takano, Takeshi**
  **Kawasaki-shi, Kanagawa 211-8588 (JP)**

(74) Representative: **Stebbing, Timothy Charles**
**Haseltine Lake LLP**
**Lincoln House, 5th Floor**
**300 High Holborn**
**London WC1V 7JH (GB)**

(54) **Delay detection circuit, distortion compensation circuit, and communication apparatus**

(57)    A delay detection circuit, including: a conversion circuit (22) which converts a time-domain signal into a frequency-domain signal or which converts a frequency-domain signal into a time-domain signal, wherein the conversion circuit is used in a signal processing circuit (10) which performs signal processing by quadrature modulation for a transmission signal, and the conversion circuit (22) outputs a delay amount of a first signal with respect to the transmission signal.

## FIG.1A

Distortion Compensation Circuit **10**

**Description**

The present invention relates to a delay detection circuit, distortion compensation circuit, and communication apparatus.

In the prior art of wireless communication, there is known a distortion compensation circuit which employs a digital predistortion method. The distortion compensation circuit is circuit which compensates for the distortion in RF signals output from an output amplifier of a communication apparatus; the digital predistortion method is a method in which, by further multiplying the distortion of the RF signals by distortion, the distortion is compensated.

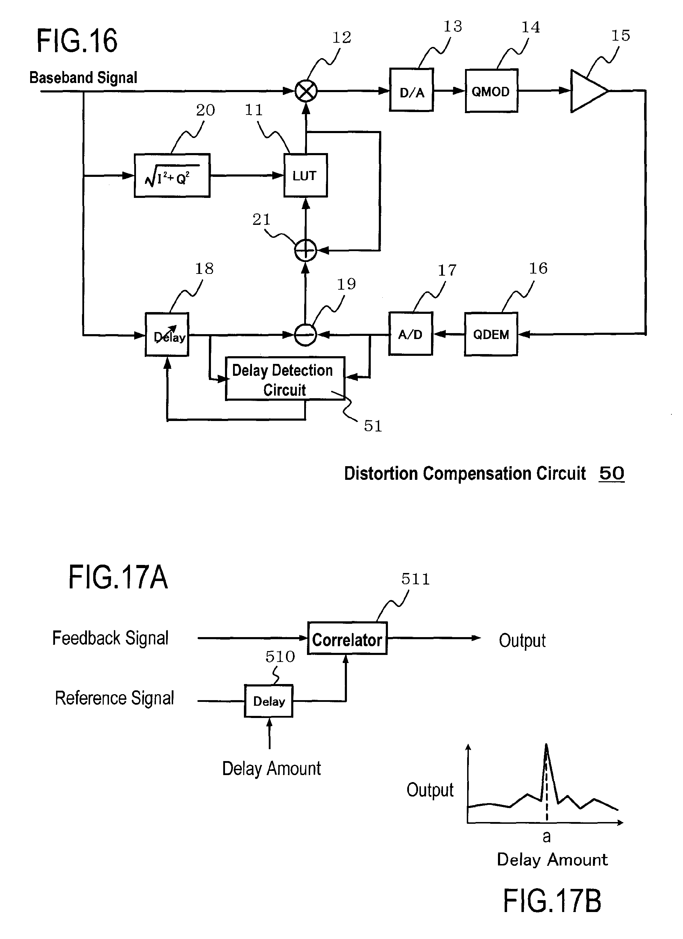

Fig. 16 is an example of the configuration of a distortion compensation circuit 50 using the digital predistortion method (see for example Japanese Patent Publication No. 4014343). The LUT (lookup table) 11 stores coefficients (distortion compensation coefficients) which provide the inverse characteristic to the distortion characteristic; the complex multiplier 12 multiplies the baseband signal with coefficients from the LUT 11. The baseband signal multiplied by coefficients passes through a D/A converter 13 and quadrature modulator (QDEM) 14 and is output to an amplifier 15. The amplifier 15 amplifies and outputs the distortion-compensated (linearity-compensated) RF signal. And, the signal is transmitted from an antenna in a later stage of the amplifier 15 to the communication destination apparatus (other party).

The distortion compensation circuit 50 updates the coefficients stored in the LUT 11. That is, a subtractor 19 detects the error between the baseband signal and a feedback signal from the amplifier 15, and an adder 21 adds the error to the coefficients of the LUT 11. Then, the coefficients stored in the LUT 11 are updated, on the basis of the added value (sum) and the amplitude of the baseband signal computed by an amplitude calculation portion 20, and thereby the distortion of the RF signal from the amplifier 15 becomes smaller.

When detecting the error, the subtractor 19 compares the baseband signal (reference signal) and the feedback signal from the amplifier 15. Because the feedback signal passes through the D/A converter 13 and quadrature modulator 14 and undergoes signal processing, the quadrature demodulator 16 and A/D converter 17 perform signal processing of the output signal from the amplifier 15.

At this time, there is a delay in feedback signals which cannot be compensated at design time, caused by the signal processing performed from the D/A converter 13 to the A/D converter 17 on the reference signals input to the subtractor 19. Hence the distortion compensation circuit 50 detects the delay amount of the reference signal and feedback signal, by means of the delay detection circuit 51, and based on the delay amount, causes the delay circuit 18 to delay the reference signal. The subtractor 19 detects the difference between the reference signal and the feedback signal in a state in which the timing of both coincides.

Fig. 17A is an example of the configuration of a delay detection circuit 51 of the prior art, and Fig. 17B is an example of delay detection in the prior art (for example, in Japanese Patent Publication No. 4014343). The delay detection circuit 51 has a delay circuit 510 and correlator 511; the delay circuit 510 delays the reference signal (baseband signal) by a prescribed delay amount, and the correlator 511 outputs the correlation value with the feedback signal. The delay amount of the delay circuit 510 is variable; the delay amount (a) for which the output is the maximum becomes the delay amount of the reference signal and feedback signal (see Fig. 17B).

However, in the distortion compensation circuit 50 of the prior art, the dedicated delay detection circuit 51 must be provided in order to detect the delay amount of the reference signal and feedback signal. For this reason, the circuit scale of the distortion compensation circuit 50 is increased.

Accordingly, it is desirable to provide a compensation circuit, a communication apparatus, and a delay detection circuit with reduced circuit scale.

One aspect of the present invention is a delay detection circuit including: a conversion circuit which converts a time-domain signal into a frequency-domain signal or which converts a frequency-domain signal into a time-domain signal, wherein the conversion circuit is used in a signal processing circuit which performs signal processing by quadrature modulation for a transmission signal, and the conversion circuit outputs a delay amount of a first signal with respect to the transmission signal.

Another aspect of the present invention is a distortion compensation circuit for compensating distortion in a transmission signal by using distortion compensation coefficient, including: a conversion circuit which converts a time-domain signal into a frequency-domain signal or which converts a frequency-domain signal into a time-domain signal; and a delay circuit which delays the transmission signal or a feedback signal, based on an output of the conversion circuit, wherein the conversion circuit is used in a signal processing circuit which performs signal processing by quadrature modulation for transmission signal; the conversion circuit outputs a delay amount of the feedback signal, with respect to the transmission signal, fed back from output side of the signal processing circuit, or an amount determined from the delay amount; and the distortion compensation coefficient is updated, based on the transmission signal delayed on a basis of the delay amount, or based on the feedback signal delayed on a basis of the amount determined from the delay amount.

Another aspect of the present invention is a communication apparatus including a signal processing circuit which performs quadrature modulation for a transmission signal and transmits the quadrature modulated transmission signal, including: a conversion circuit which converts a time-domain signal into a frequency-domain signal or which converts a frequency-domain signal into a time-domain signal, wherein the conversion circuit is used in the signal processing circuit; and the conversion circuit outputs a delay amount of a first signal with respect to the transmission signal.

It is to be understood that both the foregoing general description and the following detailed description are exemplary and explanatory and are not restrictive of the invention, as claimed.

Reference is made, by way of example only, to the accompanying drawings in which:

Fig. 1A and Fig. 1B are an example of the configuration of a distortion compensation circuit;
Fig. 2 is an example of the configuration of an OFDM signal processing circuit;
Fig. 3 is an example of the configuration of a communication apparatus;
Fig. 4 is an example of the configuration of a communication apparatus;
Fig. 5 is an example of one symbol's worth of OFDM signals;
Fig. 6A and Fig. 6B are an example of an FFT inclusion range;
Fig. 7 is an output example of the FFT circuit 22;
Fig. 8 is an example of a graph of an imaginary term in FFT output;
Fig. 9 is an example of the configurations of an FFT circuit and a transmission code cancellation circuit;
Fig. 10 is an example of a graph of imaginary terms in FFT output;
Fig. 11 is an example of the configuration of a distortion compensation circuit;
Fig. 12 is an FFT circuit output example;
Fig. 13 is an example of a graph of an imaginary term of FFT output;
Fig. 14A and Fig. 14B are an example of the range of inclusion of an FFT portion;
Fig. 15 is an example of the configuration of a communication apparatus;
Fig. 16 is an example of the configuration of a conventional distortion compensation circuit;
Fig. 17A and Fig. 17B are a conventional delay detection circuit, and an example of output from the delay detection circuit, respectively.

Below, preferred embodiments of the present invention will be explained with reference to the accompanying drawings.

Embodiment 1

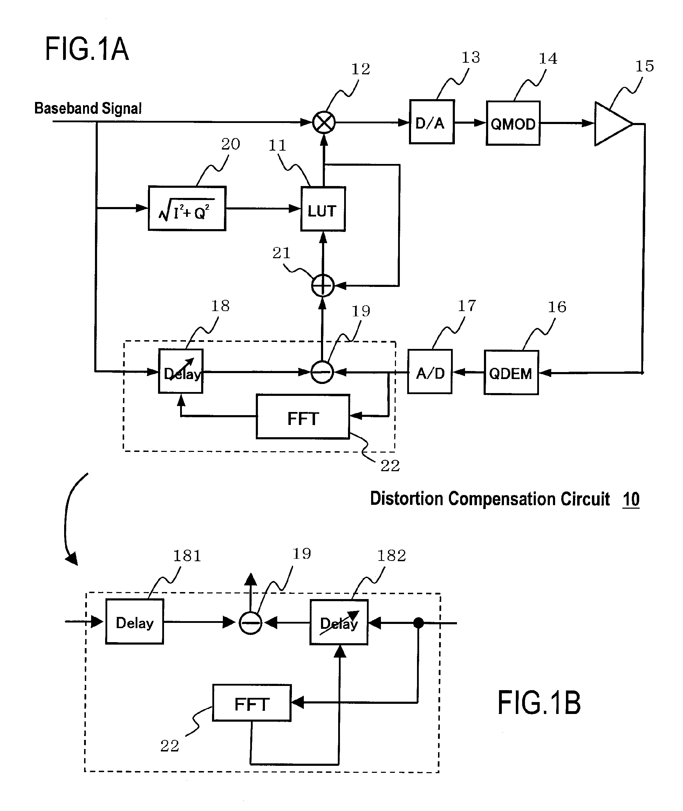

Fig. 1A is an example of the configuration of a distortion compensation circuit 10. The distortion compensation circuit 10 includes a LUT 11, complex multiplier 12, D/A converter 13, quadrature modulator (QMOD) 14, amplifier 15, quadrature demodulator (QDEM) 16, A/D converter 17, delay circuit 18, subtractor 19, amplitude calculator ($\sqrt{I^2+Q^2}$) 20, adder 21, and FFT (Fast Fourier Transform) circuit 22.

The LUT 11 stores coefficients (distortion compensation coefficients) which are the inverse characteristic of the distortion characteristic of the RF signal, in order to compensate for distortion of the RF signal output from the amplifier 15.

The complex multiplier 12 performs complex multiplication of baseband signals and coefficients from the LUT 11, and outputs the multiplied baseband signal.

The D/A converter 13 converts the baseband signal from the complex multiplier 12 into an analog signal.

The quadrature modulator 14 modulates the baseband signal from the D/A converter 13 and outputs the result as an RF signal. The quadrature modulator 14 performs, for example, QPSK (Quaternary Phase Shift Keying), 16QAM (Quadrature Amplitude Modulation), 64QAM, or other quadrature modulation.

The amplifier 15 amplifies the RF signal from the quadrature modulator 14.

The quadrature demodulator 16 demodulates the RF signal from the amplifier 15 and outputs a baseband signal. The demodulation performed in the quadrature demodulator 16 corresponds to the modulation of the quadrature modulator 14.

The A/D modulator 17 converts the baseband signal from the quadrature demodulator 16 into a digital signal, and outputs the result to the subtractor 19.

The delay circuit 18 delays the baseband signal based on the output signal (delay amount) from the FFT circuit 22, and outputs the delayed signal to the subtractor 19.

The subtractor 19 subtracts the baseband signal (the feedback signal) from the A/D converter 17 and the baseband signal (the reference signal) from the delay circuit 18 to detect the difference (the error) between the two, and outputs an error value.

The amplitude calculation portion 20 calculates the amplitude of the baseband signal and outputs it to the LUT 11.

The adder 21 adds the error value from the subtractor 19 and the coefficient output from the LUT 11, and outputs the result to the LUT 11. The LUT 11 updates the coefficient based on the amplitude value from the amplitude calculation portion 20 and the addition value from the adder 21. The LUT 11 updates coefficients such that the distortion in the RF signal from the amplifier 15 becomes small.

The FFT circuit 22 inputs the feedback signal from the A/D converter 17, converts the feedback signal, which is a time-domain signal, into a frequency-domain signal, and outputs the result to the delay circuit 18. The delay circuit 18 delays the feedback signal based on the output from the FFT circuit 22.

The distortion compensation circuit 10 can also use a FFT which is used in signal processing circuit to demodulate received signal subjected to OFDM (Orthogonal Frequency Division Multiplexing), OFDMA (Orthogonal Frequency Division Multiplexing Access), and other quadrature modulation, as a delay detection circuit within the distortion compensation circuit 10.

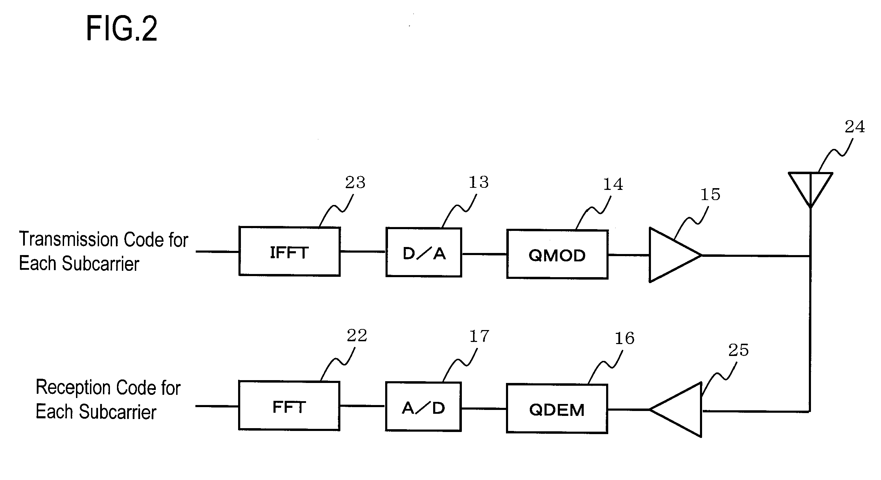

Fig. 2 is an example of the configuration of a signal processing circuit using OFDM. The signal processing circuit includes an IFFT circuit 23, D/A converter 13, quadrature modulator 14, amplifier 15, antenna 24, quadrature demodulator 16, A/D converter 17, and FFT circuit 22.

Transmission signal for each subcarrier is converted from the frequency domain to time-domain signal by the IFFT 23, the converted signal is modulated by the quadrature modulator 14 after conversion into analog signals by the D/A converter 13, and the modulated signal is transmitted from the antenna 24 after amplification by the amplifier 15.

On the other hand, a received signal received by the antenna 24 is demodulated by the quadrature demodulator 16 after amplification by the amplifier 25, and the demodulated signal is converted from time-domain signals into frequency-domain received signals for each subcarrier by the FFT circuit 22 after being converted into digital signals by the A/D converter 17

The distortion compensation circuit 10 uses the FFT circuit 22 which is used in the reception system of an OFDM signal processing circuit, as the delay detection circuit.

The FFT circuit 22 can be realized using the same circuit as the IFFT circuit 23. This is because in both cases, when the input signal is a frequency-domain signal, the output is a time-domain signal, and when the input is a time-domain signal, the output is a frequency-domain signal. Hence, the distortion compensation circuit 10 may use the IFFT circuit 23 as the delay detection circuit, in place of the FFT circuit 22.

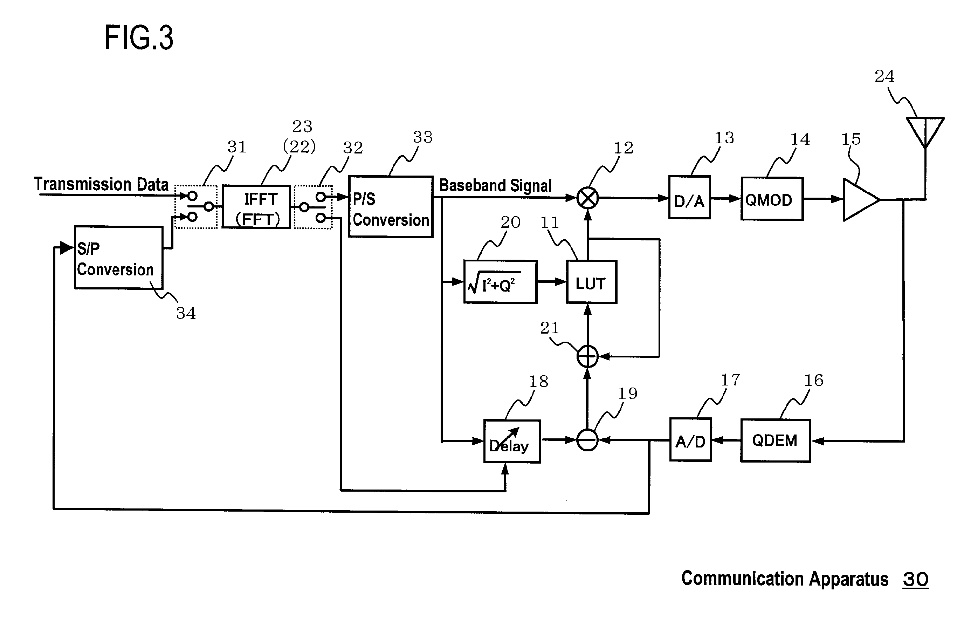

Fig. 3 is an example of the configuration of a communication apparatus 30 including the distortion compensation circuit 10. The communication apparatus 30 includes, in addition to the distortion compensation circuit 10 of Fig. 1A, a first and second switching unit 31, 32, P/S conversion unit 33, S/P conversion unit 34, and antenna 24.

The first switching unit 31 inputs the transmission data and the output from the S/P conversion unit 34, and outputs one of these to the IFFT circuit 23.

The second switching unit 32 outputs the output of the IFFT circuit 23 to either the P/S conversion unit 33 or to the delay circuit 18.

The P/S conversion unit 33 converts the output from the IFFT circuit 23 into a serial signal. The S/P conversion unit 34 converts the output from the A/D converter 17 into parallel signals.

When the communication apparatus 30 performs transmission processing using OFDM or similar, transmission data passes through the first switching portion 31, is converted from a frequency-domain signal into a time-domain signal by the IFFT circuit 23, passes through the second switching unit 32 and P/S conversion unit 33, and as the baseband signal, is subjected to quadrature modulation and other signal processing by the complex multiplier 12 and other portions. The transmission data is transmitted as an RF signal from the antenna 24.

On the other hand, when the communication apparatus 30 performs delay detection, the feedback signal output from the A/D converter 17 is converted into the parallel signal by the S/P conversion unit 34, and after passing through the first switching unit 31 is input to the IFFT circuit 23. The IFFT circuit 23, as the delay detection circuit, outputs the output, via the second switching unit 32, to the delay circuit 18. Subsequent operation is similar to that in Fig. 1A.

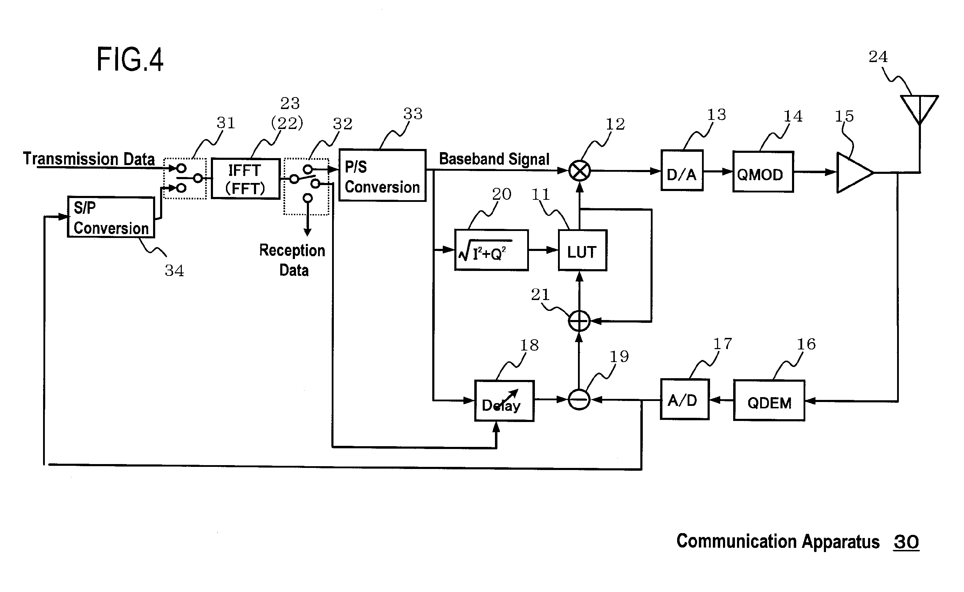

Fig. 4 is an example of the configuration of the communication apparatus 30, including the reception system as well as a OFDM transmission system. The IFFT circuit 23 is realized by the same circuit as the FFT circuit 22, and so can be used as transmission processing, as reception processing, and also as the delay detection circuit of the distortion compensation circuit 10.

Processing of transmission data and the delay detection processing of the distortion compensation circuit 10 are similar to Fig. 3. Processing of received signal is as follows. Received signal received by the antenna 24 is processed by the quadrature demodulator 16, A/D converter 17, and S/P conversion unit 34, and is output from the first switching unit 31 to the IFFT circuit 23. The IFFT circuit 23 converts the time-domain received signals to the frequency domain, and outputs the result to the second switching portion 32. The second switching unit 32 performs switching so as to output received data to another processing circuit.

Returning to Fig. 1A, the distortion compensation circuit 10 is a digital circuit up to the D/A converter 13 and following the A/D converter 17. The delay in portions comprised by digital circuitry can be calculated at the circuit design time. If there is no delay in signals (feedback signal) processed by the analog circuit from the D/A converter 13 passing through the amplifier 15 to the A/D converter 17, then the FFT circuit 22 (or IFFT circuit 23) can capture feedback signal with a certain timing.

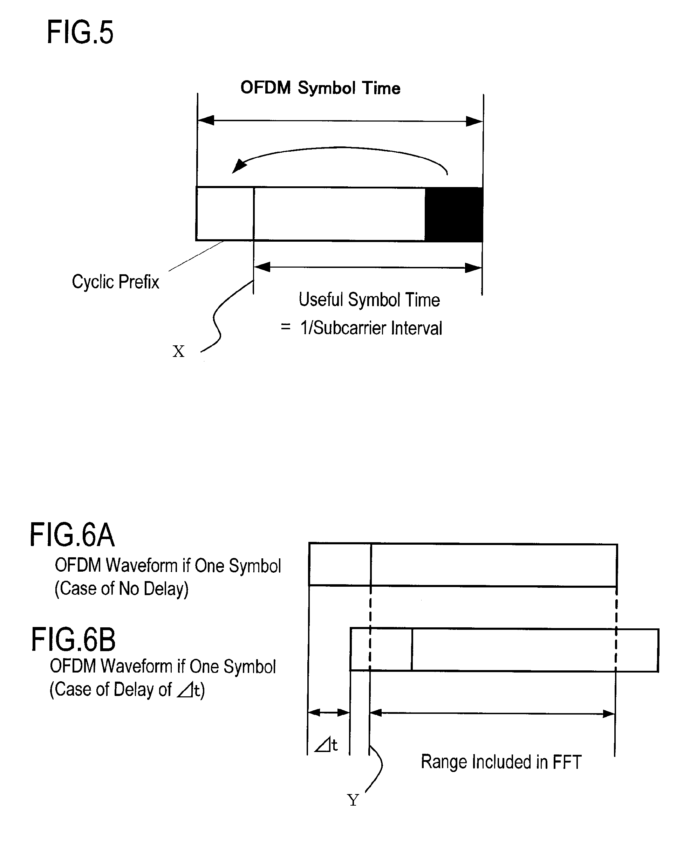

Fig. 5 is an example of one symbol's worth of OFDM signal. This is an example of OFDM signal output from the quadrature modulator 14, for example. As explained above, if the feedback signal has no delay, then the FFT circuit 22 can be designed in advance so as to capture feedback signal from immediately after the CP (Cyclic Prefix) portion (X in the figure).

However, when the FFT circuit 22 is designed in this way, signal processing is performed from the D/A converter 13 to the A/D converter 17, so that the feedback signal is delayed relative to the reference signal (baseband signal).

Fig. 6A and Fig. 6B are examples of a range of the feedback signal captured by the FFT circuit 22 if a delay is and is not present respectively. When the feedback signal is delayed by $\Delta t$, the FFT circuit 22 can capture the signal from "Y" in Fig. 6B.

Next, the ability to detect the delay from the output of the FFT circuit 22 will be explained.

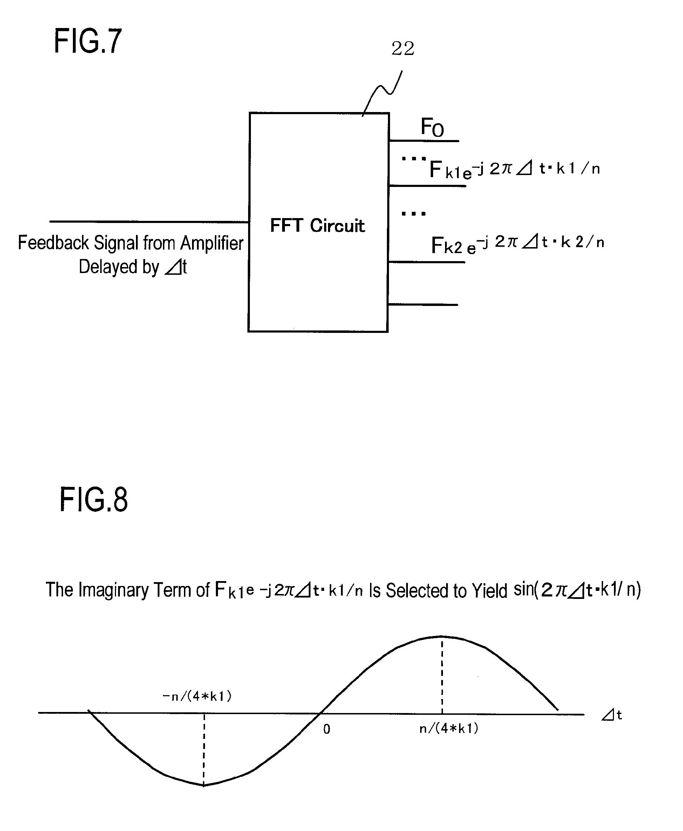

Fig. 7 shows an example of a signal series output from the FFT circuit 22. When the feedback signal is delayed relative to the reference signal by $\Delta t$, the output of the FFT circuit 22 is as follows.

$$F_k e^{-j2\pi\Delta t \cdot k / n} \qquad (1)$$

Here k is k = 0, ..., n, where n is a total number of subcarriers; $F_0$, $F_1$, ..., $F_n$ denote the respective demodulated transmission codes (transmission signals).

Here, the $F_k$ pattern that becomes $F_k=1$ is selected, and an imaginary term $(\sin(2\pi\Delta t \cdot k1/n))$ is extracted from the output (expression (1)) of the FFT circuit 22. Fig. 8 is an example of the graph of the imaginary term. The horizontal axis is the delay amount $\Delta t$, and the vertical axis is the value of the imaginary term $(\sin(2\pi\Delta t \cdot k1/n))$.

As shown in the figure, if the value of the imaginary term is positive, the delay amount $\Delta t$ becomes $\Delta t > 0$, and if the imaginary term value is negative, the delay amount becomes $\Delta t < 0$. If the value of the imaginary term is 0, the delay amount becomes $\Delta t = 0$. That is, the value of the imaginary term changes according to the delay amount $\Delta t$. The output (expression (1)) of the FFT circuit 22 also contains a real term; the value of the real term similarly changes according to the delay amount $\Delta t$. That is, the FFT circuit 22 outputs the value (expression (1)) according to the delay amount $\Delta t$.

If the output (expression (1)) of the FFT circuit 22 is output to the delay circuit 18 as the delay amount, and the delay circuit 18 inverts the sign of the output of the FFT circuit 22 and adds the value to the reference signal, then the delay circuit 18 can output the reference signal of the delay amount of the feedback signal. Hence the subtractor 19 can subtract the reference signal and feedback signal at the same timing.

In this way, the distortion compensation circuit 10 uses either the FFT circuit 22 or the IIFT circuit 23 which is used in the signal processing circuitry, as the delay detection circuit of the distortion compensation circuit 10 as well. Hence compared with a case in which a dedicated delay detection circuit is used, the circuit scale of the distortion compensation circuit 10 can be reduced.

There is another following example of the distortion compensation circuit 10 shown in Fig. 1A. Fig. 1B is an example of the configuration of the another example. A delay circuit 182 is provided between the A/D converter 17 and the subtractor 19. The FFT circuit 22 is provided between the A/D converter 17 and the delay circuit 182. A delay circuit 181 sets, as a delay on the side of the reference signal (feed-forward side), the maximum value of the delay thought to be possible on the feedback side (for example, 100 nsec). The FFT circuit 22 detects the delay of the feedback signal (for example, 30 nsec), and sets the difference (for example, 70 nsec; the amount determined from the delay amount) with the maximum value in the delay circuit 182. In this way, the delay circuit 182, to which the output from the FFT circuit 22 is input, may be on the feedback side.

Embodiment 2

In Embodiment 1, the delay circuit 18 uses the output from the FFT circuit 22 (or from the IFFT circuit 23) without modification. For example, if the subcarriers used as transmission codes can be ascertained, the subcarriers can also be used to detect delay amounts.

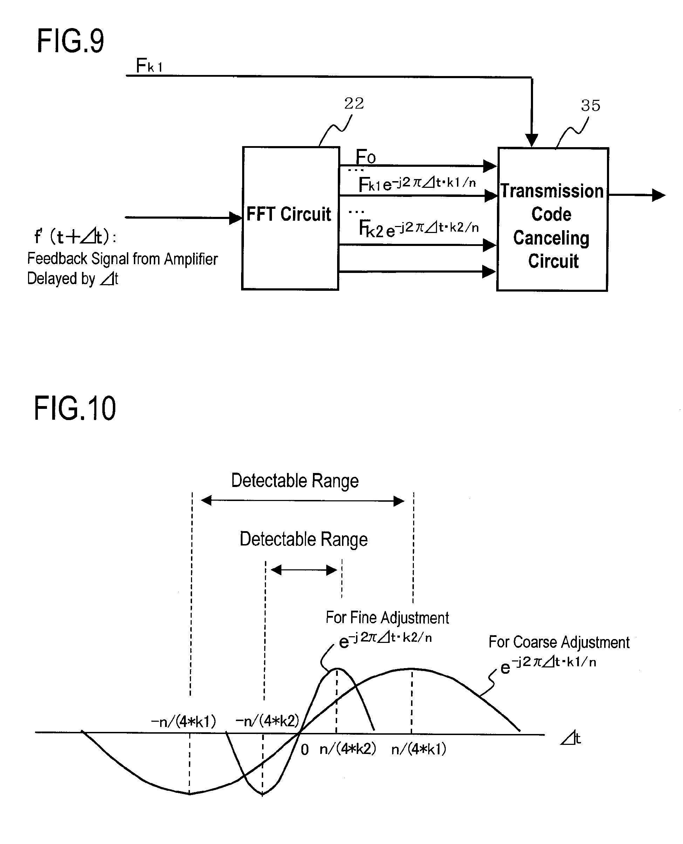

Fig. 9 is an example of the configuration of the vicinity of the FFT circuit 22. A transmission code canceling circuit 35 is provided in the stage following the FFT circuit 22; the output is input to the delay circuit 18. The FFT circuit 22 inputs the feedback signal, and outputs the FFT output for the number of subcarriers. The transmission code canceling circuit 35 inputs, for example, the transmission code $F_{k1}$ corresponding to the k1st subcarrier, together with the FFT output, selects the FFT output corresponding to the k1st subcarrier, and divides by the transmission code $F_{k1}$.

As a result, the input to the delay circuit 18 is similar to the case if a code pattern such that becomes $F_k=1$ is selected. The delay circuit 18 delays the reference signal based on the output of the transmission code canceling circuit 35. The embodiment 2 is useful when code patterns such as Fk = ±1 or ±j cannot easily be selected.

The transmission code $F_{k1}$ input to the transmission code canceling circuit 35 may for example be transmission data from the stage before the first switching portion 31 which is input to the transmission code canceling circuit 35 in Fig. 3. The transmission code canceling circuit 35 may for example temporarily store the transmission code $F_{k1}$, await the output from the FFT circuit 22, select the FFT output corresponding to the k1st subcarrier, and perform division.

Embodiment 3

As explained in Embodiment 1, the FFT circuit 22 outputs FFT output for each subcarrier according to the number of subcarriers (expression (1)). Embodiment 1 explains an example using one point thereamong. For example, a plurality of points can also be used in delay detection. Such an application example is explained below, focusing on two points.

The FFT outputs corresponding to the k1st and the k2nd subcarriers can be expressed as follows.

$$F_{k1}e^{-j2\pi\Delta t \cdot k1/n} \qquad (2)$$

$$F_{k2}e^{-j2\pi\Delta t \cdot k2/n} \qquad (3)$$

Here, k2 > k1, and the k2nd (k2-th) subcarrier frequency is higher than that of the k1st (k1-th) subcarrier.

Fig. 10 is an example of a graph of the imaginary term of each of the outputs of expressions (2) and (3). As shown in the figure, the output corresponding to the k2nd subcarrier has a narrower range of detection of the delay amount $\Delta t$ than the k1st output. However, a larger output is obtained, even for a small change in the delay amount $\Delta t$, from the k2nd than from the k1st subcarrier. That is, the output for a subcarrier of higher frequency has a smaller detection width of the delay amount $\Delta t$, but is larger value, even for a small change in the delay amount $\Delta t$, than at a lower frequency.

Utilizing these characteristics, the resolution (number of bits) of detection of the delay amount $\Delta t$ can also be adjusted. For example, when the delay amount $\Delta t$ can be represented using a larger number of bits, the k2nd output, at a higher frequency, can be used to detect the delay, and when the delay amount $\Delta t$ can be represented using a smaller number of bits, the k1st output at the lower frequency can be used. The output from the FFT circuit 22 may be used according to the number of bits that can be used by the delay circuit 18.

In addition, for example, the delay circuit 18 can use the k1st output at the lowest frequency to delay the reference signal (coarse adjustment), and then, when the delay amount $\Delta t$ is made small, can use the k2nd output at a higher frequency to delay the signal (fine adjustment).

Embodiment 4

In Embodiment 1, delays were considered in designing the component portions of the digital circuit in advance at circuit design time; for example, design was performed such that the FFT circuit 22 captures the feedback signal with the timing of "X" in Fig. 5. The Embodiment 4 is an example in which delay detection is performed without taking delays into consideration at circuit design time.

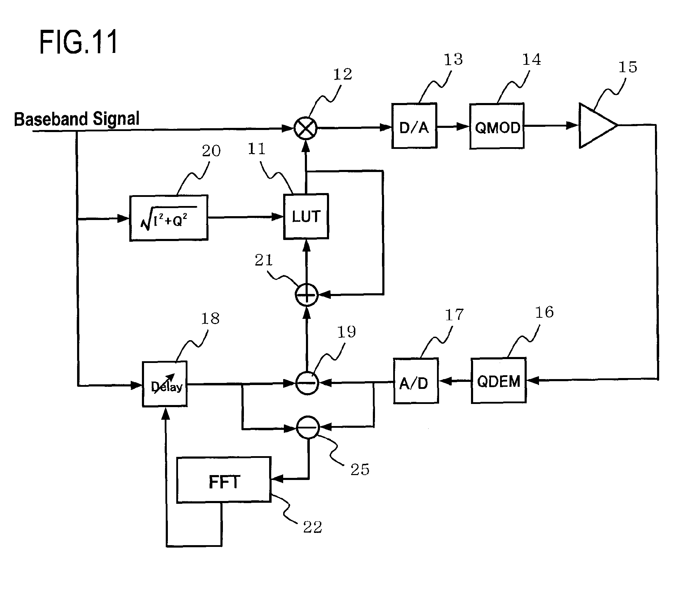

Fig. 11 is an example of the configuration of the distortion compensation circuit 10 of Embodiment 4. As shown in the figure, in the distortion compensation circuit 10 of Embodiment 4, the subtractor 25 takes the difference between the reference signal and the feedback signal, and the difference value is input to the FFT circuit 22. Here, suppose that in the input stage of the subtractor 25, a delay $\Delta tr$ occurs in the reference signal, and that a delay $\Delta tf$ occurs in the feedback signal. The delay of the feedback signal relative to the reference signal is ($\Delta tf-\Delta tr$). When the delay amount ($\Delta tf-\Delta tr$) is input to the FFT circuit 22, the output is as follows.

$$F_k(e^{-j2\pi\Delta tf \cdot k/n} - e^{-j2\pi\Delta tr \cdot k/n}) \qquad (4)$$

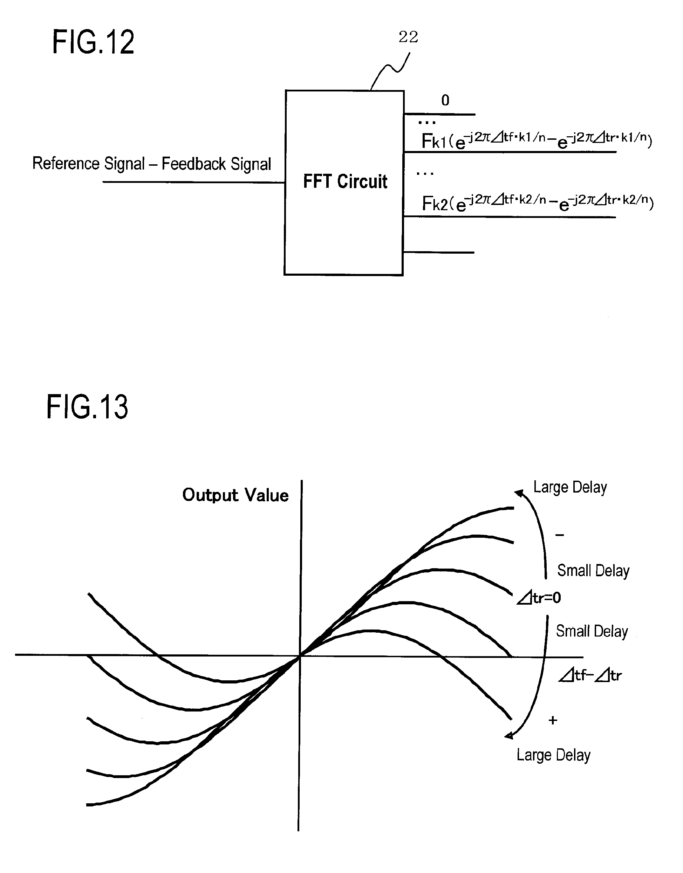

Fig. 12 is an example of a signal series output from the FFT circuit 22; Fig. 13 is a graph showing an example of the output of the imaginary term among the output of expression (4), similarly to Embodiment 1. As seen in the figure, output values have different characteristics according to the delay Δtr of the reference signal. For example, when the sample timing of the FFT circuit 22 is earlier than the timing of "X" in Fig. 5, compared with the case of Δtr = 0, the output value is larger in regions where Δtf is delayed (in Fig. 13, the "-" direction), and when earlier, the output value is smaller in regions where Δtf is delayed (the "+" direction in the figure).

In such cases also, the output from the FFT circuit 22 is input to the delay circuit 18, so that similarly to Embodiment 1, when the output is negative the reference signal delay is increased, but when the output is positive the reference signal delay is decreased. By this means, similarly to Embodiment 1, subtraction can be performed in a state in which the timing of the reference signal and the feedback signal coincide in the input stage of the subtractor 19.

Embodiment 5

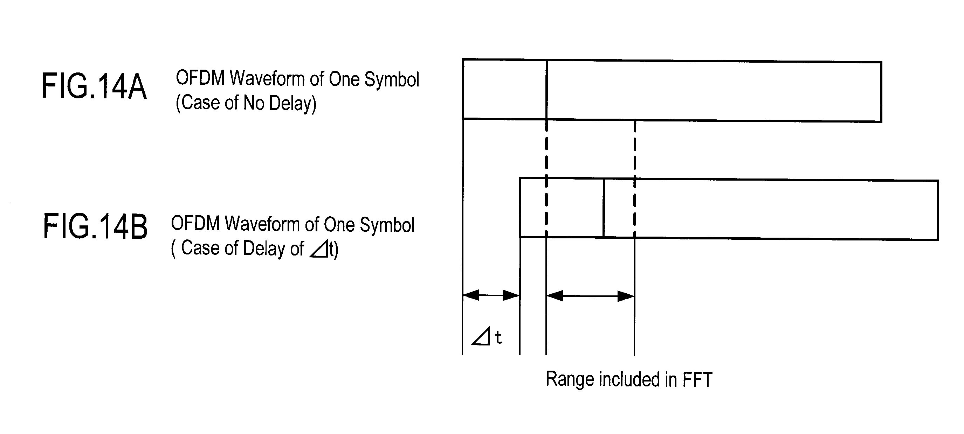

Embodiment 5 is an example in which the feedback signal capturing range for the FFT circuit 22 in Embodiment 1 and similar is a short range compared with Embodiment 1. Fig. 14A and Fig. 14B are examples.

As shown in Fig. 14B, by making the capturing range of the FFT circuit 22 short compared with that of Embodiment 1 (see Fig. 6B), output is obtained from the FFT circuit 22 in a short time, and the delay amount Δt can be detected in a short time.

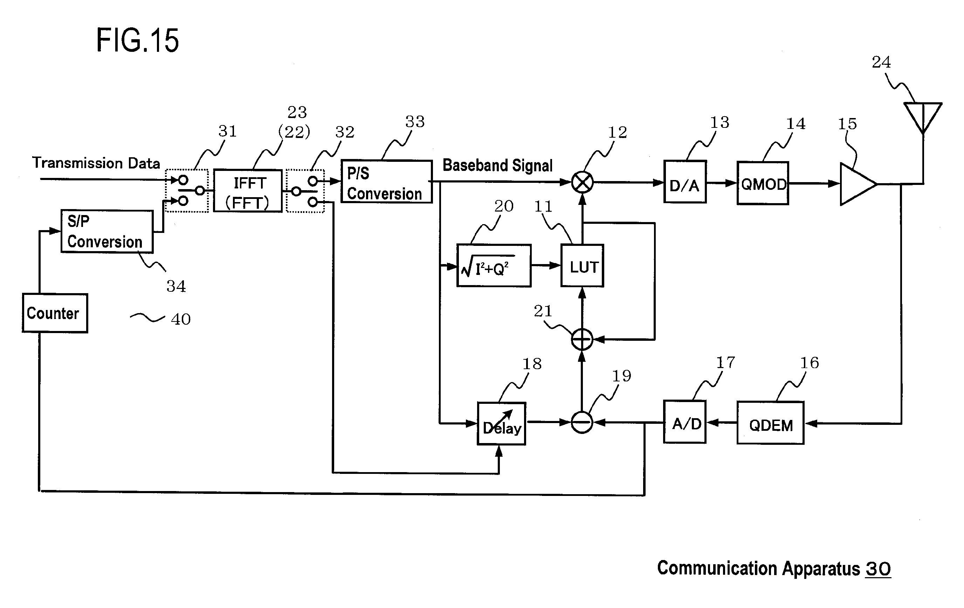

Fig. 15 is an example of the configuration of Embodiment 5. A counter 40 is provided between the A/D converter 17 and the S/P conversion portion 34. The counter 40, in which a count value is stored in advance, counts the number of input signal samples in a fixed interval, and outputs the counted input signals. By making the count value within the range shown in Fig. 14B, the capturing range of the FFT circuit 22 can be made short compared with Embodiment 1.

By means of the present invention, the distortion compensation circuit, the communication apparatus, and the delay detection circuit, with reduced circuit scale, can be provided.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present inventions have been described in detail, it should be understood that the various changes, substitutions, and alterations could be made hereto without departing from the scope of the claims.

**Claims**

1. A delay detection circuit, comprising:

    a conversion circuit which converts a time-domain signal into a frequency-domain signal or which converts a frequency-domain signal into a time-domain signal, wherein
    the conversion circuit is used in a signal processing circuit which performs signal processing by quadrature modulation for a transmission signal, and
    the conversion circuit outputs a delay amount of a first signal with respect to the transmission signal.

2. The delay detection circuit according to Claim 1, wherein the conversion circuit outputs a plurality of frequency-domain or time-domain signals for the first signal, and outputs the plurality of frequency-domain or time-domain signals as the delay amount.

3. The delay detection circuit according to Claim 1 or 2, wherein the conversion circuit inputs a difference between the transmission signal and the first signal.

4. The delay detection circuit according to Claim 1, 2, or 3, wherein the transmission signal is a reference signal, and the first signal is a feedback signal from the transmission side of the signal processing circuit.

5. The delay detection circuit according to Claim 1, 2, 3, or 4, wherein the quadrature modulation is quadrature modulation employing OFDM or OFDMA.

6. A distortion compensation circuit for compensating distortion in a transmission signal by using distortion compensation coefficient, comprising:

    a conversion circuit which converts a time-domain signal into a frequency-domain signal or which converts a frequency-domain signal into a time-domain signal; and a delay circuit which delays the transmission signal or a feedback signal, based on an output of the conversion circuit, wherein
the conversion circuit is used in a signal processing circuit which performs signal processing by quadrature modulation for the transmission signal;
the conversion circuit outputs a delay amount of the feedback signal, with respect to the transmission signal, fed back from output side of the signal processing circuit, or an amount determined from the delay amount; and
the distortion compensation coefficient is updated, based on the transmission signal delayed on a basis of the delay amount, or based on the feedback signal delayed on a basis of the amount determined from the delay amount.

7.  The distortion compensation circuit according to Claim 6, further comprising a transmission code canceling circuit which inputs the transmission signal and an output from the conversion circuit, and cancels a transmission code of the transmission signal on the basis of the output from the conversion circuit, wherein
an output of the transmission code canceling circuit is input to the delay circuit.

8.  The distortion compensation circuit according to Claim 6, wherein the signal processing circuit performs signal processing by quadrature modulation employing OFDM or OFDMA.

9.  A communication apparatus including a signal processing circuit which performs quadrature modulation for a transmission signal and transmits the quadrature modulated transmission signal, comprising:

a conversion circuit which converts a time-domain signal into a frequency-domain signal or which converts a frequency-domain signal into a time-domain signal, wherein
the conversion circuit is used in the signal processing circuit; and the conversion circuit outputs a delay amount of a first signal with respect to the transmission signal.

10. The communication apparatus according to Claim 9, wherein the signal processing circuit performs signal processing by quadrature modulation employing OFDM or OFDMA.

# FIG.1A

Baseband Signal

$\sqrt{I^2 + Q^2}$

LUT

D/A

QMOD

Delay

FFT

A/D

QDEM

Distortion Compensation Circuit **10**

Delay

FFT

Delay

**FIG.1B**

# FIG.2

Transmission Code for
Each Subcarrier —— **IFFT** (23) —— **D／A** (13) —— **QMOD** (14) —— ▷ (15) —— antenna (24)

Reception Code for
Each Subcarrier —— **FFT** (22) —— **A／D** (17) —— **QDEM** (16) —— ◁ (25)

EP 2 117 116 A2

# FIG.3

Communication Apparatus **30**

# FIG.4

Communication Apparatus **30**

# FIG.5

**OFDM Symbol Time**

Cyclic Prefix

X

Useful Symbol Time
= 1/Subcarrier Interval

# FIG.6A

OFDM Waveform if One Symbol
(Case of No Delay)

# FIG.6B

OFDM Waveform if One Symbol
(Case of Delay of $\Delta t$)

$\Delta t$

Y

Range Included in FFT

# FIG.7

22

FFT Circuit

Feedback Signal from Amplifier
Delayed by $\Delta t$

$F_0$

$\cdots F_{k1}e^{-j2\pi\Delta t \cdot k1/n}$

$\cdots$

$F_{k2}e^{-j2\pi\Delta t \cdot k2/n}$

# FIG.8

The Imaginary Term of $F_{k1}e^{-j2\pi\Delta t \cdot k1/n}$ Is Selected to Yield $\sin(2\pi\Delta t \cdot k1/n)$

$-n/(4*k1)$

$0$

$n/(4*k1)$

$\Delta t$

# FIG.9

$F_{k1}$

22

$f'(t+\Delta t):$
Feedback Signal from Amplifier
Delayed by $\Delta t$

→ FFT Circuit →

$F_0$
$F_{k1}e^{-j2\pi\Delta t\cdot k1/n}$
...
$F_{k2}e^{-j2\pi\Delta t\cdot k2/n}$

35

Transmission
Code
Canceling
Circuit

# FIG.10

Detectable Range

Detectable Range

For Fine Adjustment
$e^{-j2\pi\Delta t\cdot k2/n}$

For Coarse Adjustment
$e^{-j2\pi\Delta t\cdot k1/n}$

$-n/(4*k1)$   $-n/(4*k2)$   $0$   $n/(4*k2)$   $n/(4*k1)$   $\Delta t$

## FIG.11

# FIG.12

22

Reference Signal − Feedback Signal

**FFT Circuit**

0

...

$F_{k1}(e^{-j2\pi\triangle tf \cdot k1/n} - e^{-j2\pi\triangle tr \cdot k1/n})$

...

$F_{k2}(e^{-j2\pi\triangle tf \cdot k2/n} - e^{-j2\pi\triangle tr \cdot k2/n})$

# FIG.13

**Output Value**

Large Delay

−

Small Delay

$\triangle tr=0$

Small Delay

$\triangle tf−\triangle tr$

+

Large Delay

FIG.14A  OFDM Waveform of One Symbol
(Case of No Delay)

FIG.14B  OFDM Waveform of One Symbol
( Case of Delay of $\varDelta$t)

$\varDelta$ t

Range included in FFT

EP 2 117 116 A2

# FIG.15

Communication Apparatus 30

# FIG.16

Baseband Signal

Distortion Compensation Circuit **50**

# FIG.17A

Feedback Signal

Reference Signal

Delay Amount

Output

Output

a
Delay Amount

# FIG.17B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4014343 B